**Europäisches Patentamt**

**European Patent Office**

**Office européen des brevets**

(19)

(11) Veröffentlichungsnummer: **0 231 410 B1**

(12) # EUROPÄISCHE PATENTSCHRIFT

(45) Veröffentlichungstag der Patentschrift: **10.04.91**

(51) Int. Cl.⁵: **G01D 3/02**

(21) Anmeldenummer: **86101335.7**

(22) Anmeldetag: **03.02.86**

(54) **Verfahren und Schaltung zur Messung und Anzeige physikalischer Grössen.**

(43) Veröffentlichungstag der Anmeldung:
**12.08.87 Patentblatt 87/33**

(45) Bekanntmachung des Hinweises auf die
Patenterteilung:
**10.04.91 Patentblatt 91/15**

(84) Benannte Vertragsstaaten:
**CH DE FR GB LI**

(56) Entgegenhaltungen:
**EP-A- 0 078 592**
**DE-A- 3 030 990**
**DE-A- 3 339 349**
**DE-B- 2 549 222**

(73) Patentinhaber: **LEYBOLD AKTIENGESELL-
SCHAFT**
**Bonner Strasse 498**
**W-5000 Köln 51(DE)**

(72) Erfinder: **Klein, Hans-Hermann, Dr.**
**Im Weidental 13**
**W-5064 Rösrath(DE)**
Erfinder: **Szöcs, Zoltan**
**Langenbergsweg 33A**
**W-5300 Bonn 2(DE)**

(74) Vertreter: **Leineweber, Jürgen, Dipl.-Phys.**
**Nagelschmiedshütte 8**
**W-5000 Köln 40(DE)**

## Beschreibung

Die Erfindung bezieht sich auf ein Verfahren zur Messung und Anzeige physikalischer Größen, vorzugsweise tiefer Temperaturen und tiefer Drükke, mit Hilfe eines Spannungssignale liefernden Sensors, bei welchem ein vom Sensor geliefertes Signal mit Hilfe elektronischer Mittel mit der bekannten und in den elektronischen Mitteln eingespeicherten Sensorcharakteristik verglichen und aufgrund dieses Vergleichs ein Anzeigesignal gebildet wird. Außerdem bezieht sich die Erfindung auf eine für die Durchführung des Verfahrens geeignete Schaltung.

Es ist bekannt, die Messung physikalischer Größen mit Hilfe von Sensoren vorzunehmen, die ein der zu messenden Größe entsprechendes Spannungssignal abgeben. Dabei besteht häufig das Problem, daß die Sensorcharakteristik nicht linear ist, das heißt, daß zwischen den vom Sensor gelieferten Signalen und den Werten der zu messenden physikalischen Größe, welche den Sensorsignalen entsprechen, keine lineare Abhängigkeit besteht. Insbesondere bei der Messung tiefer Temperaturen und tiefer Drücke sind Sensoren mit relativ komplizierten Charakteristiken bekannt. Bei Messungen dieser Art- vorzugsweise bei der Temperaturmessung-verwendete Sensoren sind zum Beispiel Silizium-Dioden, Widerstände aus Kohle, Ge oder Pt, Thermistoren oder Thermoelemente.

Ein Verfahren der eingangs genannten Art zur Messung und Anzeige tiefer Temperaturen ist bekannt. Als Sensor dient eine Si-Diode, deren Meßsignale über einen Analog-Digital-Wandler einem Mikroprozessor zugeführt werden. Der Mikroprozessor ist mit einer Rechenvorschrift programmiert; außerdem ist er mit der Sensorcharakteristik gefüttert. Diese Anordnung erlaubt es, zu jedem Meßsignal den zugehörigen Temperaturwert zu berechnen und anzuzeigen. Nachteilig an dieser Meßwertverarbeitung ist die Notwendigkeit der Vewendung relativ kostspieliger Bauelemente, insbesondere des Mikroprozessors. Weiterhin ist die Erstellung der erforderlichen Rechenprogramme, die Ablage dieser Programme im Mikroprozessor und die Speicherung der Sensorcharakteristik mit einem relativ hohen Aufwand verbunden, der in den Kosten für Meßgeräte dieser Art zum Ausdruck kommt. Ein weiterer Nachteil, daß ein Wechsel der Sensorart ein Auswechseln des Mikroprozessors oder zumindest eine aufwendige Änderung der Mikroprozessor-Software notwendig macht.

Zum Stand der Technik gehört auch der Inhalt der Schriften DE-B1-25 49 222 und DE-A1 33 39 349, welche sich auf Schaltungen für Kennliniengeber beziehen. Um den Meßwert zu linearisieren, erfolgt eine direkte Auswahl von Korrekturwerten aus einem Festwertspeicher durch das umgewandelte Meßsignal. Außerdem ist aus der EP-A-00 78 592 ein Komparator bekannt.

Der vorliegenden Erfindung liegt die Aufgabe zugrunde, ein Meßund Anzeige-Verfahren der eingangs genannten Art anzugeben, bei dem der Aufwand sowohl für die Hardware als auch für die Software wesentlich geringer ist.

Erfindungsgemäß wird diese Aufgabe dadurch gelöst, daß das vom Sensor gelieferte Meßsignal dem ersten Eingang eines Komparators zugeführt wird, daß dem zweiten Eingang des Komparators nacheinander und wiederholt Analogsignale zugeführt werden, die den Meßsignalen des gewünschten Meßbereichs entsprechen, daß der Komparator bei Gleichheit der Signale ein Latch (Auffang-Flipflop, Signalspeicher) aktiviert, an dem entsprechend der gespeicherten Sensorcharakteristik jeweils dasjenige Anzeigesignal vorliegt, das dem am zweiten Eingang des Komparators anliegenden Meßsignal entspricht, und daß das vom Latch durchgelassene Anzeigesignal angezeigt wird.

Der wesentliche Vorteil dieses Meßverfahrens besteht darin, daß es mit einfachen und relativ preiswerten elektronischen Komponenten realisiert werden kann. Ein Mikroprozessor ist nicht mehr erforderlich. Damit entfällt die Erstellung einer aufwendigen Software und das Ablegen der Software im Mikroprozessor. Die die Durchführung des Meßverfahrens ermöglichende Schaltung ist einfach, übersichtlich und umfaßt wenige Bauelemente. Eine vorteilhafte Weiterbildung des erfindungsgemäßen Verfahrens ist dadurch gekennzeichnet, daß mit Hilfe eines Zählers nacheinander und sich ständig wiederholend die Adressen von zwei parallel geschalteten Festwertspeichern (ROM, EPROM und dergleichen) angesteuert werden, in denen in einander entsprechenden Adressen die Analogwerte der Meßsignale und die Analogwerte der zugehörigen Anzeigesignale digital abgespeichert sind, daß die den angesteuerten Adressen des Meßsignal-Speichers entsprechenden Signale über einen Digital-Analog-Wandler dem Komparator zugeführt werden, daß die den angesteuerten Adressen des Anzeigesignal-Speichers entsprechenden Digitalsignale dem Latch zugeführt werden, daß der Komparator bei Gleichheit der Signale das Latch aktiviert und daß das bei aktiviertem Latch anliegende Anzeigesignal angezeigt wird. Bei einem Meßverfahren dieser Art ist es lediglich erforderlich, in den Adressen der Festwertspeicher die Sensorcharakteristik zu speichern; die Erstellung und Eingabe von Rechenprogrammen entfällt. Bei einem Wechsel des Sensors reicht es aus, mit dem Sensor die zugehörigen Speicher auszutauschen. Die Änderung eines Rechenprogramms entfällt ebenfalls. Die Umrüstung von Meßgeräten beim Sensor-Wechsel ist äußerst einfach.

Infolge der Verwendung eines Latchs ist aufgrund seiner Zwischenspeichereigenschaften sichergestellt, daß die Anzeige nicht flattert. Außerdem ist am Latch ein BCD-Ausgang ohne Mehraufwand verfügbar, der zum Beispiel mit einem Schreiber oder einem Rechner verbunden werden kann.

Das beschriebene Meßverfahren nach der Erfindung ist bei allen spannungsgebenden Sensoren einsetzbar. Die Meßgenauigkeit ist durch das Verfahren nicht eingeschränkt; sie wird allein durch die Genauigkeit der gespeicherten Werte bestimmt. Die Genauigkeit dieser Werte ist wiederum davon abhängig, mit welcher Genauigkeit die Sensorcharakteristik bekannt ist. Die Meßzeit ist beliebig wählbar. Sie hängt ab von der Frequenz des Zählers, mit dessen Hilfe die Speicher-Adressen angesteuert werden. Wird die Frequenz des Zählers mit Hilfe eines einstellbaren Impulsgebers gesteuert, dann ist die Meßzeit mit Hilfe dieses Impulsgebers einstellbar. Im Vergleich zu einem Meßgerät, bei dem der anzuzeigende Wert jeweils mit Hilfe eines Mikroprozessors errechnet wird, sind wesentlich kürzere Meßzeiten erreichbar. Die Auflösung hängt von der Anzahl der vorhandenen Adressen ab und ist damit beliebig erweiterbar. Dieser Vorteil ist besonders dann von Bedeutung, wenn der Wunsch besteht, die Anzeige in bestimmten Bereichen zu spreizen.

Es besteht auch die Möglichkeit, auf den Festwertspeicher, in dem die vorkommenden Meßwerte digital abgespeichert sind, zu verzichten und den Digital-Analog-Wandler direkt derart mit dem Zähler anzusteuern, daß am zweiten Eingang des Komparators eine periodisch ansteigende Analogspannung anliegt. Synchron damit wird der Festwertspeicher vom Zähler angesteuert, in dem die Anzeigesignale entsprechend der Sensorcharakteristik abgespeichert sind. Bei einer Lösung dieser Art entfällt ein Festwertspeicher und das Abspeichern von Festwerten in diesem Speicher.

Eine Schaltung zur Durchführung des beschriebenen Meßverfahrens umfaßt zweckmäßigerweise einen Komparator, ein Latch, einen Zähler und mindestens einen vom Zähler angesteuerten Festwertspeicher. Neben einem Digital-Analog-Wandler und einem Zähler sind dieses die wesentlichen Bauelemente, die zum Aufbau des Schaltung zur Durchführung des Meßverfahrens ausreichen.

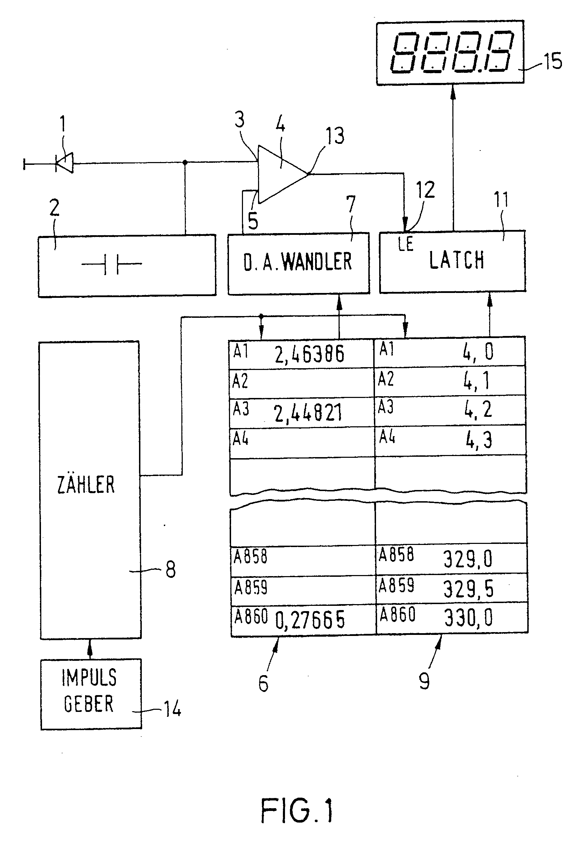

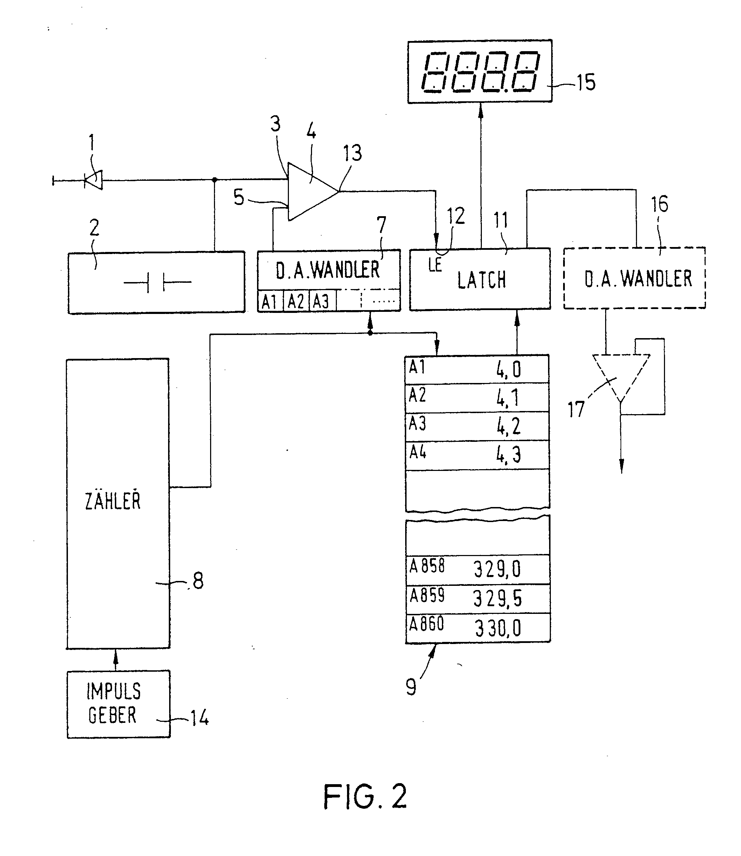

Weitere Vorteile und Einzelheiten der Erfindung sollen anhand von in den Figuren 1 und 2 dargestellten Ausführungsbeispielen erläutert werden.

In den Figuren sind der Sensor mit 1 und die zugehörige Stromquelle, welche einen konstanten Strom für den Sensor 1 liefert, mit 2 bezeichnet. Das vom Sensor 1 gelieferte Spannungssignal liegt dem einen Eingang 3 eines Komparators 4 an. Dem zweiten Eingang 5 des Komparators 4 werden nacheinander und wiederholt Analogsignale zugeführt, die den vom Sensor 1 gelieferten Meßsignalen entsprechen.

Bei dem in Fig. 1 dargestellten Ausführungsbeispiel werden die dem Eingang 5 des Komparators 4 zuzuführenden Analogsignale mit Hilfe eines Festwertspeichers 6 und eines Digital-Analog-Wandlers 7 erzeugt. In den Adressen (beispielsweise 860) des Speichers 6 sind diese analogen Spannungswerte digital gespeichert. Der Speicher 6 wird mit Hilfe des Zählers 8 derart angesteuert, daß nacheinander am Digital-Analog-Wandler 7 sämtliche Adressen des Speichers 6 anliegen. Die zugehörigen Analogwerte werden dem Eingang 5 des Komparators 4 zugeführt.

Mit der gleichen Frequenz, mit der die Adressen des Speichers 6 vom Zähler 8 angesteuert werden, werden auch die Adressen eines weiteren Festwertspeichers 9 angesteuert. Die Adressenzahl beider Speicher 6 und 9 ist gleich. In den Adressen des Speichers 9 sind diejenigen Werte der zu messenden physikalischen Größe gespeichert, die den im Speicher 6 in den zugehörigen Adressen gespeicherten Meßwerten entsprechen. Der Speicher 9 steht mit dem Latch 11 in Verbindung, dessen mit 12 bezeichneter Aktivierungseingang an den Ausgang 13 des Komparators 4 angeschlossen ist.

Das in Fig. 1 dargestellte Schaltungsbeispiel dient der Messung und Anzeige tiefer Temperaturen. In den Adressen des Speichers 9 sind die Zahlen 4 bis 330 abgelegt. Diese Zahlen entsprechen dem gewünschten Temperatur-Meßbereich, also 4 K bis 330 K. Die Abstufung erfolgt in Abhängigkeit vom vorhandenen Speicherplatz. Beim dargestellten Ausführungsbeispiel sind 860 Adressen vorhanden, so daß zum Beispiel im Bereich von 4 bis 25 K eine 0,1-Abstufung und von 25 bis 330 K eine 0,5-Abstufung gewählt werden kann.

In den 860 Adressen des Speichers 6 sind entsprechend der bekannten Sensorcharakteristik diejenigen Spannungswerte abgelegt, die dem jeweiligen Temperaturwert in der zugehörigen Adresse des Speichers 9 entsprechen.

Der Ablauf des Meßverfahrens erfolgt in der Weise, daß mit Hilfe des Zählers 8 die Adressen der beiden Speicher 6 und 9 abgefragt werden. Der Zähler 8 wird vom Impulsgeber 14 angesteuert, dessen Frequenz einstellbar ist.

Die vom Zähler 8 abgefragten Werte des Speichers 6 werden vom Digital-Analog-Wandler 7 in Analogimpulse umgewandelt und dem Eingang 5 des Komparators 4 nacheinander und wiederholt zugeführt. Parallel dazu liegen dem Latch 11 mit gleicher Frequenz und gleicher Wiederholungsrate die Werte derjenigen Adressen an, die dem jeweils am Eingang 5 des Komparators 4 anliegenden Spannungswerten entsprechen. Stimmt das vom Sensor 1 gelieferte Meßsignal mit einem aus einer bestimmten Adresse stammenden, am Eingang 5 des Komparators 4 anliegenden Spannungssignal überein, dann aktiviert der Komparator 4 den Eingang 12 des Latchs 11. Im Latch 11 ist in diesem Moment ein Anzeigewert gespeichert, der aus der korrespondierenden Adresse des Speichers 9 stammt. Dieser Wert wird vom Latch 11 zur Anzeige 15 freigegeben.

Fig. 2 zeigt eine Schaltung, bei der an das Latch 11 ein zusätzlicher Digital-Analog-Wandler 16 angeschlossen ist, der über einen Verstärker 17 ein Analogsignal liefert. Dieses Signal kann einem Schreiber oder einem Rechner zugeführt werden.

Weiterhin ist dem Speicher 9 nicht mehr ein weiterer Speicher 6 zugeordnet, in dem feste Spannungswerte gespeichert sind. Der Zähler 8 steuert den Digital-Analog-Wandler 7 direkt an. Dadurch ergibt sich am Eingang 5 des Komparators 4 eine ansteigende, periodisch sich wiederholende, sägezahnförmige Spannung, die dem Bereich der vom Sensor 1 abgegebenen Meßspannungen entspricht. Den Impulsen des Zählers 8 sind im Digital-Analog-Wandler Adressen zugeordnet, die mit den Adressen im Speicher 9 korrespondieren. Die anzuzeigenden Werte im Speicher 9 sind entsprechend der Sensorcharakteristik abgelegt, so daß bei einer bestimmten Spannung am Eingang 5 des Komparators das zugehörige Anzeigesignal dem Latch 11 anliegt. Liegt dem Eingang 3 des Komparators diese Spannung ebenfalls an, gibt das Latch den Anzeigewert zur Anzeige 15 frei.

## Ansprüche

1. Verfahren zur Messung und Anzeige physikalischer Größen, vorzugsweise tiefer Temperaturen und tiefer Drücke, mit Hilfe eines Spannungssignale liefernden Sensors (1), bei welchem ein vom Sensor geliefertes Signal mit Hilfe elektronischer Mittel mit der bekannten und in den elektronischen Mitteln eingespeicherten Sensorcharakteristik verglichen und aufgrund dieses Vergleichs ein Anzeigesignal gebildet wird, **dadurch gekennzeichnet,** daß das Meßsignal dem ersten Eingang (3) eines Komparators (4) zugeführt wird, daß dem zweiten Eingang (5) des Komparators nacheinander und wiederholt Analogsignale zugeführt werden, die den Meßsignalen des gewünschten Meßbereichs entsprechen, daß der Komparator bei Gleichheit der Signale ein Latch (11) aktiviert, an dem entsprechend der gespeicherten Sensorcharakteristik jeweils dasjenige Anzeigesignal anliegt, das dem am zweiten Eingang des Komparators anliegenden Meßsignal entspricht, und daß das vom Latch durchgelassene Anzeigesignal angezeigt wird.

2. Verfahren nach Anspruch 1, **dadurch gekennzeichnet,** daß mit Hilfe eines Zählers (8) nacheinander und sich ständig wiederholend die Adressen von zwei parallel geschalteten Festwertspeichern (6, 9) angesteuert werden, in denen in einander entsprechenden Adressen die Analogwerte der Meßsignale und die Analogwerte der zugehörigen Anzeigesignale digital abgespeichert sind, daß die den angesteuerten Adressen des Meßsignal-Speichers (6) entsprechenden Signale über einen Digital-Analog-Wandler (7) dem Komparator (4) zugeführt werden, daß die den angesteuerten Adressen des Anzeigesignal-Speichers (9) entsprechenden Digital-Signale einem Latch (11) zugeführt werden, daß der Komparator (4) bei Gleichheit der Signale das Latch (11) aktiviert und daß das bei aktiviertem Latch anliegende Anzeigesignal angezeigt wird.

3. Verfahren nach Anspruch 1, dadurch gekennzeichnet , daß mit Hilfe eines Zählers (8) ein Digital-Analg-Wandler (7) derart angesteuert wird, daß an dem mit dem Ausgang des Digital-Analog-wandlers verbundenen zweiten Eingang (5) des Komparators (4) eine periodisch ansteigende Analogspannung anliegt, daß der Zähler synchron dazu die Adressen eines Festwertspeichers (9) ansteuert, in dem die Anzeigesignale entsprechend der Sensorcharakteristik abgespeichert sind,

daß die den angesteuerten Adressen des AnzeigesignalSpeichers (9) entsprechenden Digital-Signale einem Latch (11) zugeführt werden, daß der Komparator (4) bei Gleichheit der Signale das Latch (11) aktiviert und daß das bei aktiviertem Latch anliegende Anzeigesignal angezeigt wird.

4. Verfahren nach Anspruch 2 oder 3, dadurch gekennzeichnet , daß die Frequenz des Zählers (8) mit Hilfe eines einstellbaren Impulsgebers (14) gesteuert wird.

5. Schaltung zur Durchführung des Verfahrens nach Anspruch 1 mit einem Spannungssignale liefernden Sensor (1) und mit elektronischen Mitteln, mit deren Hilfe ein vom Sensor (1) geliefertes Signal mit einer in den elektronischen Mitteln eingespeicherten Sensorcharakteristik verglichen und aufgrund dieses Vergleichs ein Anzeigesignal gebildet wird, dadurch gekennzeichnet, daß der Sensor (1) mit einem ersten Eingang (3) eines Komparators (4) verbunden ist, daß der zweite Eingang (5) des Komperators über einem Digital-Analog-Wandler (7) an eine elektronische Einrichtung (6, 8) angeschlossen ist, welche einen Zähler (8) umfaßt und nacheinander und sich ständig wiederholend Signale liefert, die den Meßsignalen des gewünschten Meßbereichs entsprechen, daß der Ausgang des Komparators (4) mit dem Aktivierungseingang (12) eines Latch (11) verbunden ist, das seinerseits mit einem vom Zähler (8) angesteuerten Speicher (9) in Verbindung steht, in welchem Anzeigesignale gespeichert sind, und daß an den Ausgang des Latch (11) eine Anzeige (15) angeschlossen ist.

6. Schaltung nach Anspruch 5 zur Durchführung des Verfahrens nach Anspruch 2, dadurch gekennzeichnet , daß der zweite Eingang (5) des Komparators (4) über den Digital-Analog-Wandler (7) an einen vom Zähler (8) angesteuerten Speicher (6)angeschlossen ist, welcher nacheinander und sich ständig wiederholend Signale liefert, die den Meßsignalen des gewünschten Meßbereichs entsprechen.

7. Schaltung nach Anspruch 5 zur Durchführung des Verfahrens nach Anspruch 3, dadurch gekennzeichnet , daß der zweite Eingang (5) des Komparators am Ausgang des Digital-Analog-Wandlers (7) angeschlossen ist, der vom Zähler (8) derart angesteuert wird, daß am Eingang (5) des Komperators eine periodisch ansteigende Analogspannung anliegt.

## Claims

1. Process for measuring and indicating physical values, preferably low temperatures and low pressures, with the aid of a sensor (1) which supplies voltage signals, in which case a signal supplied by the sensor is compared by electronic means with the known sensor characteristic stored in the electronic means, and on the basis of this comparison an indicator signal is formed, characterised in that the measurement signal is supplied to the first input (3) of a comparator (4), in that analog signals corresponding to the measurement signals of the desired measuring range are supplied consecutively and repeatedly to the second input (5) of the comparator, in that when the signals are equal the comparator actuates a latch (11), to which according to the stored sensor characteristic in each case the indicator signal is applied which corresponds to the measurement signal applied to the second input of the comparator, and in that the indicator signal allowed through by the latch is indicated.

2. Process according to claim 1, characterised in that the addresses of two fixed value memories (6, 9) which are connected in parallel and in which the analog values of the measurement signals and the analog values of the associated indicator signals are digitally stored in mutually corresponding addresses, are actuated by means of a counter (8) consecutively and in constant repetition, in that the signals corresponding to the actuated addresses of the measurement signal memory (6) are supplied to the comparator (4) via a digital-analog converter (7), in that the digital signals corresponding to the actuated addresses of the indicator signal memory (9) are supplied to a latch (11), in that the comparator (4) actuates the latch (11) when the signals are equal, and in that the indicator signal applied when the latch is actuated is indicated.

3. Process according to claim 1, characterised in that a digital-analog converter (7) is actuated by means of a counter (8) in such a manner that a periodically increasing analog voltage is applied to the second input (5) of the comparator (4) connected to the output of the digital-analog converter, in that the counter at the same time actuates the addresses of a fixed value memory (9), in which the indicator signals are stored according to the sensor characteristic, in that the digital signals corresponding to the actuated addresses of the indicator signal memory (9) are supplied to a latch (11), in that the comparator (4) actuates the latch (11) when the signals are equal, and in that the indicator signal applied when the latch is actuated is indicated.

4. Process according to claim 2 or 3, characterised in that the frequency of the counter (8) is controlled by means of an adjustable pulse generator (14).

5. Switchgear for carrying out the process according to claim 1, with a sensor (1) supplying voltage signals and with electronic means, with which a signal supplied by the sensor (1) is compared with a sensor characteristic stored in the electronic means, and on the basis of this comparison an indicator signal is formed, characterised in that the sensor (1) is connected to the first input (3) of a comparator (4), in that the second input (5) of the comparator is connected via a digital-analog converter (7) to an electronic device (6, 8), which comprises a counter (8) and supplies signals consecutively and in constant repetition, which correspond to the measurement signals of the desired measuring range, in that the output of the comparator (4) is connected to the actuating input (12) of a latch (11), which is in turn connected to a memory (9) actuated by the counter (8), indicator signals being stored in the memory (9), and in that an indicator (15) is connected to the output of the latch (11).

6. Switchgear according to claim 5 for carrying out the process according to claim 2, characterised in that the second output (5) of the comparator (4) is connected via the digital-analog converter (7) to a memory (6) actuated by the counter (8), this memory supplying consecutive, constantly repeating signals which correspond to the measuring signals of the desired measuring range.

7. Switchgear according to claim 5 for carrying out the process according to claim 3, characterised in that the second input (5) of the comparator is connected to the output of the digital-analog converter (7), which is actuated by the counter (8) in such a manner that a periodically increasing analog voltage is applied to the input (5) of the comparator.

## Revendications

1. Procédé de mesure et de visualisation de grandeurs physiques, en particulier de basses températures et de basses pressions, à l'aide d'un détecteur (1) qui fournit des signaux de tension, procédé dans lequel un signal fourni par le détecteur est comparé, à l'aide de moyens électroniques, avec la caractéristique du détecteur, connue et mémorisée dans les moyens électroniques, et dans lequel, sur la base de cette comparaison, se forme un signal de visualisation, caractérisé par le fait que l'on amène le signal de mesure à la première entrée (3) d'un comparateur (4), que l'on amène à la seconde entrée (5) du comparateur, successivement et de façon répétitive, des signaux analogiques qui correspondent aux signaux de mesure de la plage de mesure désirée, par le fait qu en cas d'égalité des signaux le comparateur active un verrou électronique (11) auquel, en correspondance avec la caractéristique du détecteur mémorisée, arrive respectivement le signal de visualisation qui correspond au signal de mesure qui arrive à la seconde entrée des comparateurs, et par le fait que le signal de visualisation que laisse passer le verrou électronique est visualisé.

2. Procédé selon la revendication 1, caractérisé par le fait qu'à l'aide d'un compteur (8), sont appelés, successivement et de façon répétitive en permanence, les adresses de deux mémoires fixes (6, 9) qui sont montées en parallèle et dans les adresses, se correspondant les unes aux autres, desquelles, sont mémorisées en numérique des valeurs analogiques des signaux de mesure et des valeurs analogiques des signaux de visualisation correspondants, par le fait que les signaux, correspondants aux adresses appelées de la mémoire (6) des signaux de mesure, sont amenés, par l'intermédiaire d'un transducteur numérique-analogique (7), au comparteur (4), par le fait que les signaux numériques correspondants aux adresses appelées de la mémoire (9) des signaux de visualisation sont amenés à un verrou électronique (11), par le fait qu'en cas d'égalité des signaux, le comparateur (4) active le verrou électronique (11) et par le fait que le signal de visualisation, arrivant du fait de l'activation du verrou électronique, est visualisé.

3. Procédé selon la revendication 1, caractérisé par le fait qu'à l'aide d'un compteur (8) un transducteur numérique-analogique (7) est activé de façon telle qu'une tension analogique croissant périodiquement arrive à la seconde entrée (5), reliée à la sortie du transducteur numérique-analogique, du comparateur (4), par le fait que le compteur appelle, en synchronisme avec cela, les adresses d'une mémoire fixe (9) dans laquelle sont mémorisés les signaux de visualisation correspondant à la caractéristique du détecteur, par le fait que les signaux numériques, correspondant aux adresses appelées de la mémoire (9) des signaux de visualisation sont amenés à un verrou électronique (11), par le fait qu'en cas d'égalité des signaux, le comparateur (4) active le verrou électronique (11) et par le fait que le signal de visualisation, arrivant du fait de l'activation du verrou électronique, est visualisé.

4. Procédé selon la revendication 2 ou 3, caractérisé par le fait que la fréquence du compteur (8) est commandée à l'aide d'un émetteur d'impulsions (14) réglable.

5. Circuit pour la mise en oeuvre du procédé conforme à la revendication 1, comportant un détecteur (1) qui fournit des signaux de tension, ainsi que des moyens électroniques à l'aide desquels un signal fourni par le détecteur (1) est comparé avec une caractéristique du détecteur mémorisée dans les moyens électroniques et un signal de visualisation se forme sur la base de cette comparaison, caractérisé par le fait que le détecteur (1) est relié à une première entrée (3) d'un comparateur (4), par le fait que la seconde entrée (5) du comparateur est reliée, par l'intermédiaire d'un transducteur numérique-analogique (7), à un circuit électronique (6, 8) qui comporte un compteur (8) et qui fournit, successivement et se répétant en permanence, des signaux qui correspondent aux signaux de mesure de la plage de mesure désirée, par le fait que la sortie du comparateur (4) est reliée avec l'entrée d'activation (12) d'un verrou électronique (11) qui, de son côté, est relié avec une mémoire (9) qui est appelée par le compteur (8) et dans laquelle sont mémorisés les signaux de visualisation, et par le fait qu'un visuel (15) est relié à la sortie du verrou électronique (11).

6. Circuit selon la revendication 5 pour la mise en oeuvre du procédé selon la revendication 2, caractérisé par le fait que la seconde entrée (5) du comparateur (4) est reliée, par l'intermédiaire du transducteur numérique-analogique (7), à une mémoire (6) qui est appelée par le compteur (8) et qui fournit, successivement et se répétant en permanence, des signaux qui correspondent aux signaux de mesure de la plage de mesure désirée.

7. Circuit selon la revendication 5 pour la mise en oeuvre du procédé selon la revendication 3, caractérisé par le fait que la seconde entrée (5) du comparateur est reliée à la sortie du transducteur numérique-analogique (7) qui est commandée, par le compteur (8), de façon telle qu'à l'entrée (5) du comparateur arrive une tension analogique périodiquement croissante.

FIG.1

FIG. 2